## Europäisches Patentamt

## European Patent Office

## Office européen des brevets

(19)

(11) Veröffentlichungsnummer: **0 015 997**
**B1**

(12) # EUROPÄISCHE PATENTSCHRIFT

(45) Veröffentlichungstag der Patentschrift:
**07.03.84**

(51) Int. Cl.³: **H 01 L 23/34, H 01 L 23/42**

(21) Anmeldenummer: **79900536.8**

(22) Anmeldetag: **25.05.79**

(86) Internationale Anmeldenummer:
**PCT/CH 79/00078**

(87) Internationale Veröffentlichungsnummer:
**WO 80/00511 (20.03.80 Gazette 80/6)**

(54) **KÜHLEINRICHTUNG FÜR VERLUSTWÄRMEERZEUGENDE ELEKTRISCHE UND/ODER ELEKTRONISCHE BAUELEMENTE.**

(30) Priorität: **26.08.78 DE 2837353**

(43) Veröffentlichungstag der Anmeldung:
**01.10.80 Patentblatt 80/20**

(45) Bekanntmachung des Hinweises auf die Patenterteilung:
**07.03.84 Patentblatt 84/10**

(84) Benannte Vertragsstaaten:
**CH FR GB SE**

(56) Entgegenhaltungen:
**FR - A - 2 071 964**
**FR - A - 2 122 413**
**US - A - 3 656 540**

**Siemens-Zeitschrift, 44. Jg. (1970), Seiten 39-43**

(73) Patentinhaber: **BBC Aktiengesellschaft Brown, Boveri & Cie., Haselstrasse, CH-5401 Baden (CH)**

(72) Erfinder: **KLEIN, Erwin, Dresdnerstrasse 5, D-6805 Heddesheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Kühleinrichtung für verlustwärmeerzeugende elektrische und/oder elektronische Bauelemente

Die Erfindung bezieht sich auf eine Kühleinrichtung für verlustwärmeerzeugende elektrische und/oder elektronische Bauelemente nach dem Oberbegriff des Patentanspruchs 1.

Bei einer bekannten Kühleinrichtung der eingangs genannten Gattung dienen bei direkter Flüssigkeitskühlung der Halbleiterbauelemente Wasser oder Öl als Kühlmittel (Siemens-Zeitschrift 44 (1970), H. 1, Seiten 39 bis 43).

Dabei kann die erwärmte Kühlflüssigkeit mittels eines zwangsbelüfteten Wärmeaustauschers oder mittels eines zweiten Flüssigkeitskreislaufes rückgekühlt werden. Die Wasserkühlung ist effektiver als die Ölkühlung; jedoch hat selbst chemisch reines Wasser das Bestreben, aus seiner Umgebung Ionen in Lösung zu bringen, so dass ein Ionenaustauscher notwendig ist, um ein gewisses Isoliervermögen des Wassers aufrechtzuerhalten. Weiterhin friert Wasser unter 273 K ein. Isolierendes Transformatoröl begünstigt im Fall von Leckagen Staubablagerungen und kann so zur Beeinträchtigung der elektronischen Spannungsfestigkeit führen. Diese Gefahr besteht auch bei Verwendung von Silikonöl.

Die Erfindung, wie sie in den Ansprüchen gekennzeichnet ist, löst die Aufgabe, eine preiswerte Kühleinrichtung der eingangs genannten Gattung zu schaffen, die bei möglichst geringem Bauvolumen einen möglichst hohen Wirkungsgrad erreicht.

Als Kühlmittel für eine derartige Kühleinrichtung eignen sich z.B. Derivate des Methans oder des Äthans in geeigneten Verbindungen. Vorteilhaft kann somit ein Teil der Wärme, wie üblich, über einen zwangsbelüfteten bzw. Konvektions-Wärmeaustauscher, der andere Teil über die Kälteanlage bzw. einen Sekundärkühlmittelkreislauf abgeführt werden.

Der Verflüssiger der Kältekreislaufanlage ist dabei in den zwangsbelüfteten Wärmeaustauscher des Primärkühlmittelkreislaufes eingebaut, womit eine weitere Entlastung oder eine geringere Dimensionierung des Wärmeaustauschers möglich ist.

Bei der eingangs beschriebenen bekannten Flüssigkeitskühlung erfolgt die Wärmeableitung vornehmlich durch Konvektion. Bei der erfindungsgemässen Auswahl eines Kühlmittels, dessen Siedepunkt etwas unterhalb der Wandtemperatur des zu kühlenden Bauelementes liegt, tritt neben der Konvektion in Teilbereichen auch noch Wärmeabfuhr durch Sieden ein, so dass ein höherer Wirkungsgrad erreicht wird.

Als Kühlmittel wird vorzugsweise $C_2F_3Cl_3$ gewählt. Unter Zugrundelegung der Temperaturverhältnisse, die z.B. in der für die Flüssigkeitskühlung von Leistungs-Halbleiterbauelementen verwendbaren Kühldosen gemäss der DE-OS 2 640 000 herrschen, wäre an sich ein Kühlmittel mit einem Siedepunkt zwischen 328 und 333 K wünschenswert. Die Verbindung $C_2F_3Cl_3$ (Typ 113) mit einem Siedepunkt von 320,6 K stellt die derzeit beste Annäherung an diesen Temperaturbereich dar. Allerdings ist wegen des relativ niedrigen Siedepunktes dieser Verbindung der Temperaturgradient zum Rückkühlen (Verflüssigen) des Kühlmittels sehr klein. Er beträgt z.B. bei einer Umgebungstemperatur von 313 K nur 7,6 K, so dass an sich ein sehr umfangreicher Wärmeaustauscher notwendig wäre. Anderseits sind bei der Kühlung von Stromrichterschaltungen oft erhebliche Verlustleistungen bis zu einigen 100 kW abzuführen. Eine Kälteanlage, über die die Gesamtleistung umgesetzt werden müsste, würde zu voluminös werden und hätte einen zu schlechten Wirkungsgrad. Die Aufteilung der Verlustleistung auf die zwangsbelüfteten Wärmeaustauscher und die Kälteanlage stellt daher eine optimale Lösung dar. Damit ist es möglich, den Wärmeaustauscher in einer Grösse zu bauen, die rein konvektiv arbeitenden Wärmeaustauschern entspricht. Ausserdem ist man in der Lage, je nach Leistung der Kälteanlage, das Kühlmittel sogar unter die Temperatur der Umgebungsluft zu bringen, womit man die verlustwärmeerzeugenden Bauelemente effektiver kühlen kann.

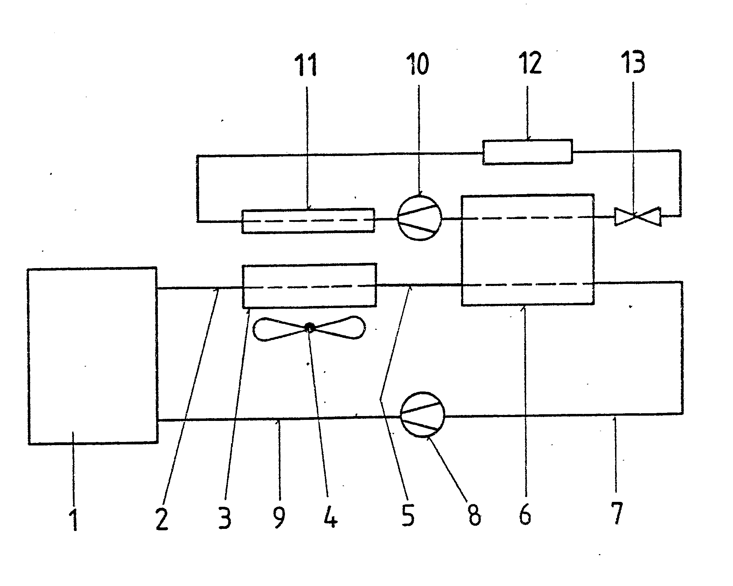

Die Erfindung wird nachfolgend anhand der in der Zeichnung dargestellten Ausführungsbeispiele näher erläutert.

Das Ausführungsbeispiel bezieht sich auf die Kühlung eines Stromrichters 1. Ein Primärkühlmittelkreislauf umfasst, in Strömungsrichtung betrachtet, eine Leitung 2, einen Wärmeaustauscher 3, dem ein Ventilator 4 zugeordnet ist, eine Leitung 5, einen Verdampfer 6, eine Leitung 7, eine Pumpe 8 und eine z.B. zu den Kühldosen der Halbleiterbauelemente des Stromrichters 1 zurückführende Leitung 9.

Der Verdampfer 6 wirkt als Wärmeaustauscher zwischen dem Primärkühlmittelkreislauf und dem Sekundärkühlmittelkreislauf, der, vom Verdampfer 6 aus in Strömungsrichtung betrachtet, enthält: einen Kompressor 10, einen Verflüssiger 11, einen Sammler 12 und ein Expansionsventil 13.

Die Kühleinrichtung hat folgende Wirkungsweise:

An den wärmeabgebenden Flächen z.B. von Kühldosen der Leistungs-Halbleiterbauelemente des Stromrichters 1 verdampft das Kühlmittel des Primärkühlmittelkreislaufs teilweise. Das teils gasförmige, teils flüssige Kühlmittel wird über die Leitung 2 zum Wärmeaustauscher 3 geführt, wo ein grosser Teil der Wärme durch mittels des Lüfters 4 bewirkte Konvektion an die Umgebung abgeführt wird, jedoch noch keine vollständige Verflüssigung des Kühlmittels eintritt. Diese erfolgt erst dann, wenn das Kühlmittel über die Leitung 5 den Verdampfer 6 der Kälteanlage durchströmt. Dabei kann die Temperatur des Kühlmittels mehr oder weniger unter ihrem Siedepunkt liegen. Über die Leitung 7, die Pumpe 8 und die Leitung 9 wird dann das Kühlmittel wieder zur Wärmeaufnahme zum Stromrichter 1 zurückbefördert. Der Sekundärkühlmittelkreislauf ist eine aus üblichen Teilen bestehende Kälteanlage und arbeitet in bekannter Weise. Zweckmässig ist der Verflüssiger 11 in den Wärmeaustauscher 3 des Primärkühlmittelkreislaufes eingebaut, weil er mit höheren Temperaturen arbeiten kann. Damit wird zwar praktisch keine Lüfterleistung eingespart – nur Wirkungsgradanteile –, jedoch wird erheblich an Volumen dieser Teile und der für diese notwendigen Kosten gespart.

Vorteilhaft kann im Primärkühlmittelkreislauf mit relativ niedrigen Drücken gearbeitet werden, die hauptsächlich durch Strömungsverluste entstehen, weil der Gasdruck des bevorzugt gewählten Kühlmittels $C_2F_3Cl_3$ (Frigen Typ 113) sich bei den genannten Temperaturen um weniger als 1 bar erhöht.

Der Einsatz von Kältemitteln, vornehmlich des Typs Frigen 113, für die Kühlung von elektronischen Komponenten ist an sich bekannt (Wiss. Ber. AEG-Telefunken 51 (1978) 1, S. 30–39; Bull. ASE/UCS 68 (17.12.1977) 24, S. 1314–1317).

Aus dieser Literatur geht hervor, dass wegen des geringen Temperaturgradienten zwischen Umluft und Siedepunkt des Kältemittels mit einem Kältemittel-Wasserkreislauf gearbeitet wird. Die weitere Version, dass dann die Rückkühlung des Wassers mit Luft geschehen kann, ist nur dann relevant, wenn die Umgebungstemperaturen niedrig genug liegen. Verständlich ist diese Ausführung allerdings nicht; denn wenn solche niedrigen Temperaturen vorliegen, kann man auch direkt das Kältemittel mit der Umluft zurückkühlen und so mit besserem Wirkungsgrad arbeiten.

Die erfindungsgemässe Kombination von Wärmeaustauscher 3 und in Reihe geschaltetem Verdampfer 6 arbeitet bei geringem Aufwand überraschend wirkungsvoll.

Die Kühleinrichtung erlaubt es auch, die Gesamtverlustleistung über den Wärmeaustauscher abzuführen, so dass erst oberhalb einer vorbestimmten Umgebungstemperatur ein Teil der Verlustwärme dem Verdampfer der Kälteanlage zugeführt bzw. von diesem abgeführt wird. Man kann den Wärmeaustauscher 3 auf die mittlere Jahrestemperatur hin dimensionieren, falls sich bei derselben ein ausreichender Temperaturgradient für das Abführen der Gesamtverlustleistung ergibt. Solange die vorbestimmte, über der mittleren Jahrestemperatur liegende Umgebungstemperatur nicht überschritten wird, kann also die Kälteanlage abgeschaltet werden, so dass in der grössten Zeit des Jahres mit einem besseren Wirkungsgrad rückgekühlt werden kann.

Die Kälteanlage kann einerseits bei sehr heissen Raumtemperaturen neben der Kühlung des Stromrichters 1 zur Kühlung der Steuerelektronik herangezogen werden, andererseits kann sie auch zur Klimatisierung von Aufenthaltsräumen für Personen dienen.

Schliesslich erlaubt die Kühleinrichtung nicht nur die gemäss dem bevorzugten Verfahren mögliche Verwendung eines Kühlmittels, dessen Siedepunkt etwas unterhalb der Wandtemperatur des zu kühlenden Bauelementes liegt, sondern auch die Verwendung eines höher siedenden Kühlmittels, bei dem dann bei allen vorkommenden Umgebungstemperaturen das Prinzip der Aufteilung der Verlustleistung auf den Wärmetauscher 3 und den Verdampfer 6 zur Anwendung kommt.

**Patentansprüche**

1. Kühleinrichtung für verlustwärmeerzeugende elektrische und/oder elektronische Bauelemente, insbesondere für Leistungshalbleiterbauelemente
a)  mit einem Primärkühlmittelkreislauf, der mit den zu kühlenden Bauelementen in thermischer Verbindung steht, und
b)  mit einem Konvektions-Wärmeaustauscher (3) zur Kühlung des Kühlmittels des Primärkühlmittelkreislaufs,
c)  mit wenigstens einem Ventilator,
dadurch gekennzeichnet,
d)  dass innerhalb dieses Primärkühlmittelkreislaufs diesem Konvektions-Wärmeaustauscher (3) ein Verdampfer (6) nachgeordnet ist,
e)  dass dieser Verdampfer thermisch an einem Sekundärkühlmittelkreislauf mit Kompressor (10), Verflüssiger (11), Sammler (12) und Expansionsventil (13) angeschlossen ist,
f)  dass dieser Verflüssiger (11) in den Konvektions-Wärmeaustauscher (3) eingebaut ist, und
g)  dass der Primärkühlmittelkreislauf ein für kombinierte Konvektions- und Siedekühlung geeignetes Kühlmittel aufweist, dessen Siedepunkt etwas unterhalb der Wandtemperatur des zu kühlenden Bauelements (1) liegt.

2. Kühleinrichtung nach Anspruch 1, dadurch gekennzeichnet, dass das Kühlmittel Trifluortrichloräthan ($C_2F_3Cl_3$) ist.

**Claims**

1. Cooling device for electrical and/or electronic components which generate lost heat, in particular for power semi-conductor components
a)  with a primary coolant circulation which is in thermal connection with the components to be cooled and
b)  with a convection heat exchanger (3) for cooling the coolant of the primary coolant circulation,
c)  with at least one fan,
characterised in
d)  that, within this primary coolant circulation, a vapouriser (6) is arranged downstream of this convection heat exchanger (3),
e)  that this vapouriser is thermally connected to a secondary coolant circulation with a compressor (10), a liquefier (11), a receiver (12) and an expansion valve (13),
f)  that this liquefier (11) is built into the convection heat exchanger (3), and
g)  that the primary coolant circulation contains a coolant which is suitable for combined convective and evaporative cooling and the boiling point of which is just below the wall temperature of the component (1) which is to be cooled.

2. Cooling device according to Claim 1, characterised in that the coolant is trifluorotrichloroethane ($C_2F_3Cl_3$).

## Revendications

1. Dispositif de refroidissement pour composants électriques et/ou électroniques produisant de la chaleur de dissipation, en particulier pour des composants semi-conducteurs de puissance:

a)   comportant un circuit d'agent de refroidissement primaire qui est en liaison thermique avec les composants à refroidir, et

b)   un échangeur de chaleur à convection (3) pour refroidir l'agent de refroidissement du circuit d'agent de refroidissement primaire;

c)   muni d'au moins un ventilateur; caractérisé en ce que:

d)   dans ce circuit d'agent de refroidissement primaire un évaporateur (6) est monté en aval de l'échangeur de chaleur à convection (3);

e)   cet évaporateur est raccordé thermiquement à un circuit d'agent de refroidissement secondaire comportant un compresseur (10), un condenseur (11), un collecteur (12) et une valve de détente (13),

f)   ce condenseur (11) est incorporé dans l'échangeur de chaleur à convection (3), et

g)   le circuit d'agent de refroidissement primaire présente un agent de refroidissement convenant pour le refroidissement combiné par convection et par ébullition, le point d'ébullition de cet agent de refroidissement étant légèrement inférieur à la température de la paroi du composant (1) à refroidir.

2. Dispositif de refroidissement suivant la revendication 1, caractérisé en ce que l'agent de refroidissement est du trifluorotrichloréthane ($C_2F_3Cl_3$).